# FASCICULE DE BREVET EUROPEEN

(11) **EP 3 048 703 B1**
(45) Date de publication et mention de la délivrance du brevet: **06.10.2021**
(21) Numéro de dépôt: 15305057.0
(22) Date de dépôt: 20.01.2015
(51) Int. Cl.: H02K 1/28, H02K 15/00, H02K 17/16

(54) **MASSE MAGNÉTIQUE POUR ROTOR, ROTOR, MACHINE ÉLECTRIQUE ET PROCÉDÉ DE FABRICATION DE CETTE MASSE**
MAGNETISCHE MASSE FÜR ROTOR, ENTSPRECHENDER ROTOR, ENTSPRECHENDE ELEKTRISCHE MASCHINE UND HERSTELLUNGSVERFAHREN FÜR DIESE MASSE
MAGNETIC MASS FOR ROTOR, CORRESPONDING ROTOR, ELECTRIC MACHINE AND MANUFACTURING METHOD FOR THAT MASS

(43) Date de publication de la demande: 27.07.2016
(73) Titulaire: GE Energy Power Conversion Technology Ltd, Rugby Warwickshire CV21 1BU (GB)
(72) Inventeur: Galmiche, Christophe, 54200 TOUL (FR); Ayllon, Stéphane, 54200 LAGNEY (FR)
(74) Mandataire: Casalonga

(56) Documents cités:
- WO-A2-2011/141435
- DE-A1-102012 110 157
- None

## Description

La présente invention concerne une masse magnétique pour un rotor de machine électrique et concerne également un tel rotor. La présente invention concerne également une machine électrique comprenant un tel rotor. La présente invention se rapporte également à un procédé de fabrication d'une telle masse magnétique.

Le document EP- 0 609 645 A1 décrit un rotor comprenant une masse magnétique et une cage de court-circuit. La cage de court-circuit comprend deux couronnes de court-circuit et une pluralité de barres conductrices chacune reliant électriquement les couronnes de court-circuit. La masse magnétique comporte un empilement de tôles rotoriques et des tirants longitudinaux de maintien de l'empilement qui traversent les tôles magnétiques rotoriques.

Le document WO 2011/141435 A2 décrit également des tirants longitudinaux destinés à maintenir les tôles de la masse magnétique du rotor.

Le but de l'invention est donc de proposer une masse magnétique ayant un maintien des tôles et une rigidité amélioré.

A cet effet, l'invention a pour objet une masse magnétique selon la revendication 1.

Les tôles magnétiques rotoriques sont ainsi non perforées en leur centre, ce qui diminue leurs contraintes mécaniques lors de rotations à grandes vitesses.

Suivant d'autres aspects avantageux de l'invention, la masse magnétique comprend une ou plusieurs des caractéristiques suivantes, prise(s) isolément ou suivant toutes les combinaisons techniquement possibles :
- les premiers trous longitudinaux et les deuxièmes trous longitudinaux sont équirépartis angulairement dans un plan sensiblement perpendiculaire à l'axe de rotation ;
- la première distance est comprise entre 200 mm et 550 mm, de préférence comprise entre 225 mm et 500 mm, préférentiellement entre 325 mm et 450 mm ;
- la somme du nombre de premiers trous longitudinaux et du nombre de deuxièmes trous longitudinaux est supérieure à 18, de préférence supérieure à 30, préférentiellement supérieure à 40;
- la masse magnétique comprend en outre au moins un troisième trou longitudinal traversant, chaque troisième trou longitudinal étant propre à recevoir un troisième tirant respectif et étant à une troisième distance par rapport à l'axe de rotation selon une direction radiale sensiblement perpendiculaire à l'axe de rotation , la troisième distance étant distincte respectivement de la première distance et de la deuxième distance , et au moins un troisième tirant, le ou chaque troisième tirant étant reçu dans un troisième trou longitudinal respectif.

L'invention a également pour objet un rotor de machine électrique mobile autour d'un axe de rotation, comprenant une masse magnétique telle que définie ci-dessus, et une cage de court-circuit s'étendant selon l'axe de rotation et comportant deux couronnes de court-circuit placées de part et d'autre de la masse magnétique suivant l'axe de rotation, et une pluralité de barres électriquement conductrices, chacune reliant électriquement les deux couronnes de court-circuit.

En outre, l'invention se rapporte aussi à une machine électrique en particulier machine asynchrone, notamment moteur, comprenant un stator et un rotor tel que défini ci-dessus.

L'invention concerne également un procédé de fabrication d'une masse magnétique de rotor de machine électrique telle que définie dans la revendication 8.

D'autres caractéristiques et avantages de l'invention apparaîtront à la lecture de la description qui suit de modes de réalisation de l'invention, donnés uniquement à titre d'exemple non limitatif, et en référence aux dessins sur lesquels :
- la figure 1 est une vue schématique en coupe axiale d'une machine électrique selon l'invention, et
- la figure 2 est une vue en coupe de la masse magnétique du rotor de la figure 1, suivant un plan perpendiculaire à l'axe de rotation du rotor.

De façon conventionnelle dans la présente invention, l'expression « sensiblement égal à » exprimera une relation d'égalité à plus ou moins 5%.

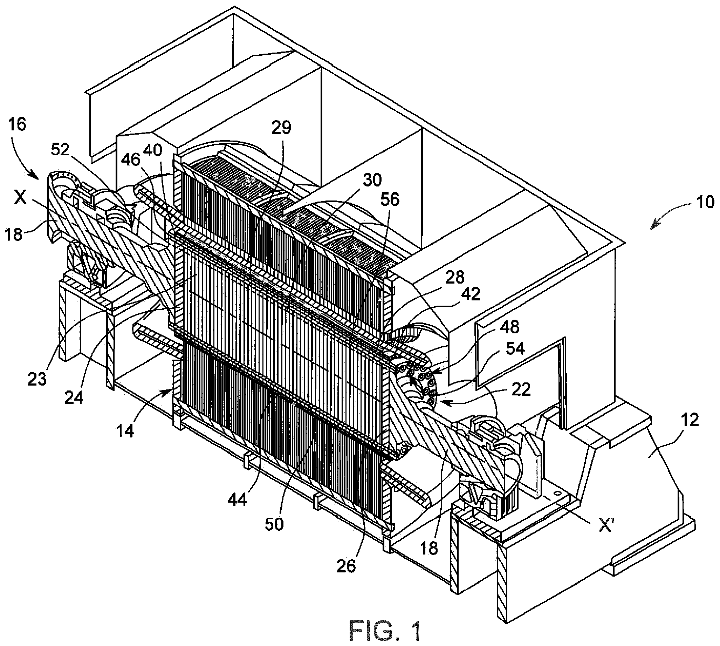

Sur la figure 1 est représentée une machine électrique selon l'invention, désignée par la référence générale 10. La machine électrique 10 est, de préférence, une machine asynchrone, notamment un moteur asynchrone.

La machine électrique 10 comprend une carcasse 12, un stator 14, un rotor 16 et deux arbres 18.

La machine 10 est adaptée pour fonctionner à des très hautes vitesses, par exemple allant de 3 000 tours/minute à 30 000 tours/minute et est de forte puissance électrique, par exemple supérieure à 10 mégawatts (MW), de préférence supérieure à 50 MW.

La carcasse 12 et le stator 14 sont des éléments connus, et ne sont donc pas décrits plus en détail.

Le rotor 16 définit un axe de rotation X-X' également appelé axe longitudinal. Dans ce qui suit, les expressions « axialement », « radialement » et « circonférentiellement » seront utilisées par rapport à l'axe X-X'.

Le rotor 16 est solidaire des arbres 18, et comprend une cage de court-circuit 22 et une masse magnétique 23.

Le rotor 16 est un rotor de masse importante, par exemple supérieure à 300 kilogrammes (kg), de préférence supérieure à 10 000 kilogrammes.

La cage de court-circuit 22 comprend une première couronne de court-circuit 24 électrique, une deuxième couronne de court-circuit 26 et une pluralité de barres 28 électriquement conductrices.

La masse magnétique 23 comporte un empilement de tôles rotoriques et des premiers tirants 29 et des deuxièmes tirants 30 de maintien de l'empilement.

La masse magnétique 23 s'étend selon l'axe longitudinal X-X' et est délimitée par une périphérie.

La masse 23 comporte une pluralité de logements de barre 32, une pluralité de premiers trous longitudinaux 34 traversants aptes à recevoir les premiers tirants 29 et une pluralité de deuxièmes trous longitudinaux 35 traversants aptes à recevoir les deuxièmes tirants 30.

La première couronne de court-circuit 24 et la deuxième couronne de court-circuit 26 sont situées de part et d'autre des extrémités de la masse magnétique 23.

Chaque couronne de court-circuit 24, 26 est un disque circulaire disposé coaxialement à l'axe de rotation X-X'. La première couronne de court-circuit 24 est disposée d'un côté axial de la masse magnétique 23 tandis que la deuxième couronne de court-circuit 26 est disposée de l'autre côté axial de la masse magnétique 23.

Chaque couronne de court-circuit 24, 26 est fixée axialement par rapport à la masse magnétique 23 ou par rapport aux arbres 18. Chaque couronne de court-circuit 24, 26 est, par exemple, maintenue serrée entre les arbres 18 et la masse magnétique 23. En variante, la couronne de court-circuit 24, 26 est fixée à toute autre pièce intermédiaire des arbres 18 ou de la masse magnétique 23.

Chaque couronne de court-circuit 24, 26 est, par exemple, fabriquée en métal, de préférence fabriquée en cuivre. De préférence, chaque couronne de court-circuit 24, 26 est fabriquée d'un seul tenant, notamment d'une seule pièce.

Chaque couronne de court-circuit 24, 26 est munie d'une pluralité de cavités axiales propres à recevoir une barre 28, un premier tirant 29 ou un deuxième tirant 30.

Chaque barre 28 comporte une première partie d'extrémité 40, une deuxième partie d'extrémité 42 et une partie médiane 44 s'étendant entre les parties d'extrémité 40, 42. Les barres 28 sont, par exemple, fabriquées en métal, tel que du cuivre. Les barres 28 sont disposées parallèlement à l'axe de rotation X-X'. En outre, la partie médiane 44 a par exemple une section circulaire.

Chaque barre 28 est fabriquée d'un seul tenant, et notamment d'une seule pièce. La première partie d'extrémité 40 est liée mécaniquement et électriquement à la première couronne de court-circuit 24. La seconde partie d'extrémité 42 est également liée électriquement et mécaniquement à la seconde couronne de court-circuit 26.

Chaque premier tirant 29 comporte une première partie d'extrémité 46, une deuxième partie d'extrémité 48 et une partie médiane 50 s'étendant entre les parties d'extrémité 46, 48. Les premiers tirants 29 sont dans un matériau présentant une rigidité plus importante que le matériau des barres 28. Les premiers tirants 29 sont disposés parallèlement à l'axe de rotation X-X'. En outre la partie médiane 50 des tirants 29 a une section circulaire. Chaque premier tirant 29 est fabriqué d'un seul tenant, et notamment d'une seule pièce. Les premiers tirants 29 permettent d'assurer le maintien mécanique de l'empilement de tôles rotoriques par appui contre les couronnes des courts-circuits 24, 26, elles-mêmes en appui contre les arbres18.

Chaque deuxième tirant 30 comporte une première partie d'extrémité 52, une deuxième partie d'extrémité 54 et une partie médiane 56 s'étendant entre les parties d'extrémité 52, 54, les deuxièmes tirants sont dans un matériau présentant une rigidité plus importante que le matériau des barres 28. De préférence, le matériau des deuxièmes tirants 30 est le même que le matériau des premiers tirants 29. Les deuxièmes tirants 30 sont disposés parallèlement à l'axe de rotation X-X'. En outre, la partie médiane 56 des deuxièmes tirants 30 a une section circulaire. De préférence, la section circulaire des parties médianes 56 des deuxièmes tirants 30 est la même que la section circulaire de la partie médiane 50 des premiers tirants 29. Chaque deuxième tirant 30 est fabriqué d'un seul tenant, et notamment d'une seule pièce. Les deuxièmes tirants 30 permettent d'assurer le maintien mécanique de l'empilement de tôles rotoriques par appui contre les couronnes des courts-circuits 24, 26, elles-mêmes en appui contre les arbres 18. Les tirants 29, 30 sont, par exemple, fabriqués en métal, tel que de l'acier.

Le nombre de logements 32 de barre est le même que le nombre de barres 28. Ainsi à chaque barre, est associé un logement 32 de barre respectif. Chaque logement 32 de barre a une section transversale complémentaire de la partie médiane 44 de la barre 28. Cette section transversale est donc circulaire dans l'exemple présenté. Chaque logement 32 présente un diamètre noté ϕ1 dans la suite. En outre chaque logement 32 se prolonge au niveau des couronnes de court-circuit 24, 26 dans deux premières cavités axiales 36.

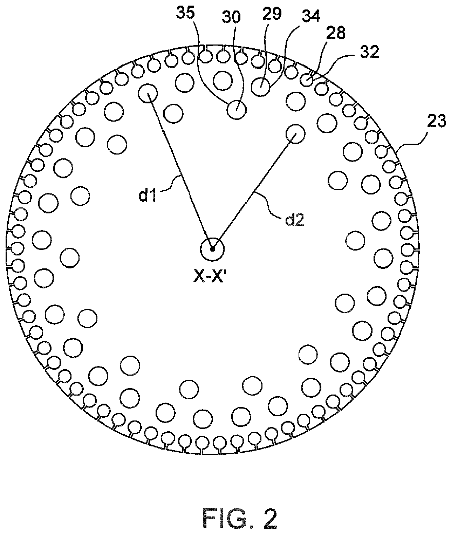

Le nombre de premiers trous longitudinaux 34 varie entre 12 et 36. Dans l'exemple de la figure 2, vingt-huit premiers trous longitudinaux 34 sont visibles. De plus, le nombre de premiers trous longitudinaux 34 traversants est le même que le nombre de premiers tirants 29. Ainsi à chaque premier tirant 29, est associé un premier trou longitudinal 34 respectif.

Chaque premier trou longitudinal 34 a une section transversale complémentaire de la partie médiane 50 du premier tirant 29. Cette section transversale est donc circulaire dans l'exemple présenté. Chaque premier trou longitudinal 34 présente un diamètre noté ϕ2 dans la suite. Le diamètre ϕ2 des premiers trous longitudinaux 34 est plus petit que le diamètre ϕ1 des logements 32. En outre, chaque premier trou longitudinal 34 se prolonge au niveau des couronnes de court-circuit 24, 26 dans deux deuxièmes cavités axiales 38.

Chaque premier trou longitudinal 34 est à une première distance d1 par rapport à l'axe longitudinal X-X' selon une direction radiale sensiblement perpendiculaire à l'axe de rotation X-X'. La première distance d1 d'un premier trou longitudinal 34 par rapport à l'axe longitudinal X-X' correspond à la distance entre le centre du premier trou longitudinal 34 et l'axe longitudinal X-X'. La première distance d1 est évaluée dans un plan perpendiculaire à l'axe longitudinal X-X', par exemple le plan de la figure 2. Une telle distance est appelée « distance radiale » dans la suite de la description. La première distance d1 est comprise entre 200 mm et 550 mm, de préférence comprise entre 225 mm et 500 mm, préférentiellement entre 325 mm et 450 mm. La valeur de la première distance d1 est identique pour tous les premiers trous longitudinaux 34 à plus ou moins 1% de préférence à plus ou moins 0,1%. La valeur de la première distance d1 est comprise entre 70% et 90% du rayon extérieur de la masse magnétique 23, de préférence comprise entre 75% et 85%.

Les premiers trous longitudinaux 34 sont équirépartis angulairement dans un plan sensiblement perpendiculaire à l'axe de rotation X-X'.

Le nombre de deuxièmes trous longitudinaux 35 varie entre 6 et 36. Dans l'exemple de la figure 2, quatorze deuxièmes trous longitudinaux 35 sont visibles. De ce fait, la somme du nombre de premiers trous longitudinaux 34 et du nombre de deuxièmes trous longitudinaux 35 est supérieure à 18, de préférence supérieure à 30, préférentiellement supérieure à 40. Cela permet de mieux répartir les premiers tirants 29 et les deuxièmes tirants 30. En outre, dans cet exemple particulier de la figure 2, le nombre de premiers trous longitudinaux 34 est égal à deux fois le nombre de deuxièmes trous longitudinaux 35. De plus, le nombre de deuxièmes trous longitudinaux 35 traversants est le même que le nombre de deuxièmes tirants 30. Ainsi à chaque deuxième tirant 30, est associé un deuxième trou longitudinal 35 respectif.

Chaque deuxième trou longitudinal 35 a une section transversale complémentaire de la partie médiane 56 du deuxième tirant 30. Cette section transversale est donc circulaire dans l'exemple présenté. Chaque deuxième trou longitudinal 35 présente un diamètre noté ϕ3 dans la suite. Le diamètre ϕ3 des deuxièmes trous longitudinaux 35 est plus petit que le diamètre ϕ1 des logements 32. Par exemple, le diamètre ϕ3 des deuxièmes trous longitudinaux 35 est plus petit que le diamètre ϕ2 des premiers trous longitudinaux 34. En outre, chaque deuxième trou longitudinal 35 se prolonge au niveau des couronnes de court-circuit 24, 26 dans deux deuxièmes cavités axiales 39.

Chaque deuxième trou longitudinal 35 est à une deuxième distance radiale d2 par rapport à l'axe longitudinal X-X'. La deuxième distance radiale d2 est distincte de la première distance d1. La deuxième distance d2 est inférieure à 95% de la première distance d1.

Dans l'exemple de la figure 1, la deuxième distance d2 est inférieure ou égale à 90% de la première distance d1. Selon une variante, la deuxième distance d2 est inférieure ou égale à 70% de la première distance d1.

Les deuxièmes trous longitudinaux 35 sont équirépartis angulairement dans un plan sensiblement perpendiculaire à l'axe de rotation X-X'.

La masse magnétique 23 est avantageusement fabriquée comme suit.

Les différentes tôles rotoriques sont d'abord réalisées puis, pour chaque tirant 29, 30, la ou les premiers et deuxièmes trous longitudinaux 34, 35 sont réalisés par découpage des tôles magnétiques de la masse magnétique 23. En outre, les logements 32 sont également découpés dans les tôles magnétiques de la masse magnétique 23. La fabrication de la masse magnétique 23 comprend l'insertion des premiers tirants 29 dans les premiers trous longitudinaux 34 et l'insertion des deuxièmes tirants 30 dans les deuxièmes trous longitudinaux 35.

La masse magnétique 23 est donc particulièrement facile à fabriquer, en compactant sous pression les tôles rotoriques contre les arbres 18. La pression de compactage exercée axialement sur les tôles rotoriques de la masse magnétique 23 est obtenue par une tension des tirants 29, 30 liés mécaniquement à leurs extrémités aux arbres 18. La contrainte de traction dans les tirants 29, 30 exerce une traction des arbres 18 l'un vers l'autre axialement permettant ainsi d'obtenir une pression axialement sur les tôles rotoriques pour le maintien mécanique de l'empilement des tôles rotoriques composant la masse magnétique 23.

En outre, une telle masse magnétique 23 permet de répartir la contrainte exercée sur les tirants longitudinaux 29, 30 en plusieurs endroits situés à des distances radiales différentes par rapport à l'axe longitudinal X-X'.

L'homme du métier comprendra que pour des rotors tournant à très grandes vitesses de rotation, avec une vitesse circonférentielle en périphérie de la masse magnétique 23 dépassant 100 mètres par seconde, l'invention permet de ne pas avoir d'arbre 18 traversant la masse magnétique 23. En effet, un arbre traversant oblige à découper un trou au centre des tôles rotoriques de la masse magnétique 23, trou servant de logement à l'arbre. Or, les contraintes mécaniques dans les tôles rotoriques dues à la force centrifuge à très grande vitesse de rotation sont trop importantes, conduisant à une déformation radiale permanente et excessive du trou central, ce qui détériore le lien mécanique entre l'arbre traversant et la masse magnétique. Sans arbre traversant, les contraintes mécaniques d'origine centrifuge au centre des tôles rotoriques sont plus faibles qu'en présence d'un trou central, permettant ainsi de réaliser des rotors tournant à de plus grandes vitesses de rotation que les rotors avec arbre traversant.

La rigidité du rotor 16 et donc de sa masse magnétique 23 sans arbre traversant est assurée par une forte pression axiale sur les tôles rotoriques, pression axiale bien plus élevée que pour un rotor avec arbre traversant. Cet effet de forte pression, permettant par adhérence entre les tôles rotoriques d'assurer le maintien mécanique de la masse magnétique 23, est obtenue par les caractéristiques de la revendication 1.

L'effet est encore accru pour une masse magnétique 23 présentant d'autres trous longitudinaux à d'autres distances radiales. Par exemple, selon une variante, la masse magnétique comprend également au moins un troisième trou longitudinal traversant, non représenté, chaque troisième trou longitudinal étant propre à recevoir un troisième tirant respectif et étant à une troisième distance d3 par rapport à l'axe de rotation selon une direction radiale sensiblement perpendiculaire à l'axe de rotation X-X', la troisième distance d3 étant distincte respectivement de la première distance d1 et de la deuxième distance d2.

## Revendications

1. Masse magnétique (23) de rotor de machine électrique, le rotor étant mobile autour d'un axe de rotation (X-X'), la masse magnétique (23) s'étendant selon l'axe de rotation (X-X') et comprenant des tôles magnétiques rotoriques non perforées en leur centre, la masse magnétique (23) comportant :
- une pluralité de premiers trous longitudinaux (34) traversants, chaque premier trou longitudinal (34) étant propre à recevoir un premier tirant (29) respectif et étant à une première distance (d1) par rapport à l'axe de rotation (X-X'), selon une direction radiale sensiblement perpendiculaire à l'axe de rotation (X-X'),
- une pluralité de premiers tirants (29), chaque premier tirant (29) étant reçu dans un premier trou longitudinal (34) respectif
**caractérisée en ce que** la masse magnétique (23) comprend, en outre :
- au moins un deuxième trou longitudinal (35) traversant, le ou chaque deuxième trou longitudinal (35) étant propre à recevoir un deuxième tirant (30) respectif et étant à une deuxième distance (d2) par rapport à l'axe de rotation (X-X') selon une direction radiale sensiblement perpendiculaire à l'axe de rotation (X-X'), la deuxième distance (d2) étant distincte de la première distance (d1),
- au moins un deuxième tirant (30), le ou chaque deuxième tirant (30) étant reçu dans un deuxième trou longitudinal (35) respectif, la deuxième distance (d2) étant inférieure ou égale à 95% de la première distance (d1), de préférence inférieure ou égale à 90% de la première distance (d1), préférentiellement inférieure ou égale à 70% de la première distance (d1), le nombre de premiers trous longitudinaux (34) étant égal à deux fois le nombre de deuxièmes trous longitudinaux (35).

2. Masse magnétique selon la revendication 1, dans laquelle les premiers trous longitudinaux (34) et les deuxièmes trous longitudinaux (35) sont équirépartis angulairement dans un plan sensiblement perpendiculaire à l'axe de rotation (X-X').

3. Masse magnétique selon l'une quelconque des revendications précédentes, dans laquelle la première distance (d1) est comprise entre 200 mm et 550 mm, de préférence comprise entre 225 mm et 500 mm, préférentiellement entre 325 mm et 450 mm.

4. Masse magnétique selon l'une quelconque des revendications précédentes, dans laquelle la somme du nombre de premiers trous longitudinaux (34) et du nombre de deuxièmes trous longitudinaux (35) est supérieure à 18, de préférence supérieure à 30, préférentiellement supérieure à 40.

5. Masse magnétique selon l'une quelconque des revendications précédentes, comprenant, en outre :
- au moins un troisième trou longitudinal traversant, chaque troisième trou longitudinal étant propre à recevoir un troisième tirant respectif et étant à une troisième distance (d3) par rapport à l'axe de rotation selon une direction radiale sensiblement perpendiculaire à l'axe de rotation (X-X'), la troisième distance (d3) étant distincte respectivement de la première distance (d1) et de la deuxième distance (d2), et
- au moins un troisième tirant, le ou chaque troisième tirant étant reçu dans un troisième trou longitudinal respectif.

6. Rotor (16) de machine électrique mobile autour d'un axe de rotation (X-X') comprenant :
- une masse magnétique (23) conforme à l'une quelconque des revendications précédentes, et
- une cage de court-circuit (22) s'étendant selon l'axe de rotation (X-X') et comportant :
- deux couronnes de court-circuit (24, 26) placées de part et d'autre de la masse magnétique (23) suivant l'axe de rotation (X-X'), et
- une pluralité de barres (28) électriquement conductrices, chacune reliant électriquement les deux couronnes de court-circuit (24, 26).

7. Machine électrique (10) en particulier machine asynchrone, notamment moteur (10), comprenant un stator (14) et un rotor (16), **caractérisée en ce que** le rotor (16) est conforme à la revendication 6.

8. Procédé de fabrication d'une masse magnétique (23) de rotor de machine électrique, le rotor étant mobile autour d'un axe de rotation (X-X'), le procédé comprenant les étapes de :
- réalisation d'une masse magnétique (23) s'étendant selon l'axe de rotation (X-X') et comprenant des tôles magnétiques rotoriques non perforées en leur centre, la masse magnétique (23) comportant :
- une pluralité de premier trous longitudinaux (34) traversants, chaque premier trou longitudinal (34) étant propre à recevoir un premier tirant (29) respectif et étant à une distance par rapport à l'axe de rotation (X-X') selon une direction radiale sensiblement perpendiculaire à l'axe de rotation (X-X') égale à une première distance (d1),
- au moins un deuxième trou longitudinal (35) traversant, le ou chaque deuxième trou longitudinal (35) étant propre à recevoir un deuxième tirant (30) respectif et étant à une distance par rapport à l'axe de rotation (X-X') selon une direction radiale sensiblement perpendiculaire à l'axe de rotation (X-X') égale à une deuxième distance (d2), la deuxième distance (d2) étant distincte de la première distance (d1),
- insertion d'une pluralité de premiers tirants (29), chaque premier tirant (29) étant inséré dans un premier trou longitudinal (34) respectif,
- insertion d'au moins un deuxième tirant (30), le ou chaque deuxième tirant (30) étant inséré dans un deuxième trou longitudinal (35) respectif, la deuxième distance (d2) étant inférieure ou égale à 95% de la première distance (d1), de préférence inférieure ou égale à 90% de la première distance (d1), préférentiellement inférieure ou égale à 70% de la première distance (d1), le nombre de premiers trous longitudinaux (34) étant égal à deux fois le nombre de deuxièmes trous longitudinaux (35).

## Patentansprüche

1. Magnetische Masse (23) eines Rotors einer elektrischen Maschine, wobei der Rotor um eine Drehachse (X-X') herum beweglich ist, wobei sich die magnetische Masse (23) entlang der Drehachse (X-X') erstreckt und in ihrer Mitte nicht gebohrte Rotormagnetbleche umfasst, wobei die magnetische Masse (23) Folgendes beinhaltet:
- eine Vielzahl von ersten länglichen Durchgangslöchern (34), wobei jedes erste längliche Loch (34) geeignet ist, um eine jeweilige erste Zugstange (29) aufzunehmen, und in einem ersten Abstand (d1) in Bezug auf die Drehachse (X-X') in einer zur Drehachse (X-X') im Wesentlichen senkrechten radialen Richtung ist,
- eine Vielzahl von ersten Zugstangen (29), wobei jede erste Zugstange (29) in einem jeweiligen ersten länglichen Loch (34) aufgenommen ist,
**dadurch gekennzeichnet, dass** die magnetische Masse (23) weiter Folgendes umfasst:
- mindestens ein zweites längliches Durchgangsloch (35), wobei das oder jedes zweite längliche Loch (35) geeignet ist, um eine jeweilige zweite Zugstange (30) aufzunehmen, und in einem zweiten Abstand (d2) in Bezug auf die Drehachse (X-X') in einer zur Drehachse (X-X') im Wesentlichen senkrechten radialen Richtung ist, wobei sich der zweite Abstand (d2) von dem ersten Abstand (d1) unterscheidet,
- mindestens eine zweite Zugstange (30), wobei die oder jede zweite Zugstange (30) in einem jeweiligen zweiten länglichen Loch (35) aufgenommen ist, wobei der zweite Abstand (d2) kleiner oder gleich 95 % des ersten Abstands (d1) ist, vorzugsweise kleiner oder gleich 90 % des ersten Abstands (d1) ist, bevorzugt kleiner oder gleich 70 % des ersten Abstands (d1) ist, wobei die Anzahl an ersten länglichen Löchern (34) gleich zweimal der Anzahl an zweiten länglichen Löchern (35) ist.

2. Magnetische Masse nach Anspruch 1, wobei die ersten länglichen Löcher (34) und die zweiten länglichen Löcher (35) winkelig gleich über eine zur Drehachse (X-X') im Wesentlichen senkrechte Ebene verteilt sind.

3. Magnetische Masse nach einem der vorstehenden Ansprüche, wobei der erste Abstand (d1) zwischen 200 mm und 550 mm enthalten ist, vorzugsweise zwischen 225 mm und 500 mm enthalten ist, bevorzugt zwischen 325 mm und 450 mm enthalten ist.

4. Magnetische Masse nach einem der vorstehenden Ansprüche, wobei die Summe der Anzahl an ersten länglichen Löchern (34) und der Anzahl an zweiten länglichen Löchern (35) größer als 18, vorzugsweise größer als 30, bevorzugt größer als 40 ist.

5. Magnetische Masse nach einem der vorstehenden Ansprüche, weiter Folgendes umfassend:
- mindestens ein drittes längliches Durchgangsloch, wobei jedes dritte längliche Loch geeignet ist, um eine jeweilige dritte Zugstange aufzunehmen, und in einem dritten Abstand (d3) in Bezug auf die Drehachse in einer zur Drehachse (X-X') im Wesentlichen senkrechten radialen Richtung ist, wobei sich der dritte Abstand (d3) jeweils von dem ersten Abstand (d1) und von dem zweiten Abstand (d2) unterscheidet, und
- mindestens eine dritte Zugstange, wobei die oder jede dritte Zugstange in einem jeweiligen dritten länglichen Loch aufgenommen ist.

6. Rotor (16) einer elektrischen Maschine, der um eine Drehachse (X-X') herum beweglich ist, Folgendes umfassend:
- eine magnetische Masse (23) nach einem der vorstehenden Ansprüche, und
- einen Kurzschlusskäfig (22), der sich entlang der Drehachse (X-X') erstreckt und Folgendes beinhaltet:
- zwei Kurzschlusskränze (24, 26), die beiderseits der magnetischen Masse (23) entlang der Drehachse (X-X') platziert sind, und
- eine Vielzahl von elektrisch leitfähigen Stäben (28), von denen jeder die beiden Kurzschlusskränze (24, 26) elektrisch verbindet.

7. Elektrische Maschine (10), insbesondere eine Asynchronmaschine, insbesondere ein Motor (10), einen Stator (14) und einen Rotor (16) umfassend, **dadurch gekennzeichnet, dass** der Rotor (16) dem Anspruch 6 entsprechend ist.

8. Verfahren zur Herstellung einer magnetischen Masse (23) eines Rotors einer elektrischen Maschine, wobei der Rotor um eine Drehachse (X-X') herum beweglich ist, wobei das Verfahren die folgenden Schritte umfasst:
- Fertigen einer magnetischen Masse (23), die sich entlang der Drehachse (X-X') erstreckt und in ihrer Mitte nicht gebohrte Rotormagnetbleche umfasst, wobei die magnetische Masse (23) Folgendes beinhaltet:
- eine Vielzahl von ersten länglichen Durchgangslöchern (34), wobei jedes erste längliche Loch (34) geeignet ist, um eine jeweilige erste Zugstange (29) aufzunehmen, und in einem Abstand in Bezug auf die Drehachse (X-X') in einer zur Drehachse (X-X') im Wesentlichen senkrechten radialen Richtung gleich einem ersten Abstand (d1) ist,
- mindestens ein zweites längliches Durchgangsloch (35), wobei das oder jedes zweite längliche Loch (35) geeignet ist, um eine jeweilige zweite Zugstange (30) aufzunehmen, und in einem Abstand in Bezug auf die Drehachse (X-X') in einer zur Drehachse (X-X') im Wesentlichen senkrechten radialen Richtung gleich einem zweiten Abstand (d2) ist, wobei sich der zweite Abstand (d2) von dem ersten Abstand (d1) unterscheidet,
- Einführen einer Vielzahl von ersten Zugstangen (29), wobei jede erste Zugstange (29) in ein jeweiliges erstes längliches Loch (34) eingeführt wird,
- Einführen mindestens einer zweiten Zugstange (30), wobei die oder jede zweite Zugstange (30) in ein jeweiliges zweites längliches Loch (35) eingeführt wird, wobei der zweite Abstand (d2) kleiner oder gleich 95 % des ersten Abstands (d1) ist, vorzugsweise kleiner oder gleich 90 % des ersten Abstands (d1) ist, bevorzugt kleiner oder gleich 70 % des ersten Abstands (d1) ist, wobei die Anzahl an ersten länglichen Löchern (34) gleich zweimal der Anzahl an zweiten länglichen Löchern (35) ist.

## Claims

1. Magnetic mass (23) for a rotor of an electric machine, the rotor being movable about an axis of rotation (X-X'), the magnetic mass (23) extending along the axis of rotation (X-X') and comprising magnetic rotor plates non-perforated at the centre thereof, the magnetic mass (23) including:
- a plurality of first longitudinal through-holes (34), each first longitudinal hole (34) being capable of receiving a first respective tie-rod (29) and being at a first distance (d1) relative to the axis of rotation (X-X'), along a radial direction substantially perpendicular to the axis of rotation (X-X'),
- a plurality of first tie-rods (29), each first tie-rod (29) being received in a first respective longitudinal hole (34)
**characterised in that** the magnetic mass (23) further comprises:
- at least one second longitudinal through-hole (35), the or each second longitudinal hole (35) being capable of receiving a second respective tie-rod (30) and being at a second distance (d2) relative to the axis of rotation (X-X') along a radial direction substantially perpendicular to the axis of rotation (X-X'), the second distance (d2) being different from the first distance (d1),
- at least one second tie-rod (30), the or each second tie-rod (30) being received in a second respective longitudinal hole (35), the second distance (d2) being less than or equal to 95% of the first distance (d1), preferably less than or equal to 90% of the first distance (d1), preferentially less than or equal to 70% of the first distance (d1), the number of first longitudinal holes (34) being equal to twice the number of second longitudinal holes (35).

2. Magnetic mass according to claim 1, wherein the first longitudinal holes (34) and the second longitudinal holes (35) are equidistributed angularly in a plane substantial perpendicular to the axis of rotation (X-X').

3. Magnetic mass according to any one of the preceding claims, wherein the first distance (d1) is between 200 mm and 550 mm, preferably between 225 mm and 500 mm, preferentially between 325 mm and 450 mm.

4. Magnetic mass according to any one of the preceding claims, wherein the sum of the number of first longitudinal holes (34) and the number of second longitudinal holes (35) is greater than 18, preferably greater than 30, preferably greater than 40.

5. Magnetic mass according to any one of the preceding claims, further comprising:
- at least one third longitudinal through-hole, each third longitudinal hole being capable of receiving a third respective tie-rod and being at a third distance (d3) relative to the axis of rotation along a radial direction substantially perpendicular to the axis of rotation (X-X'), the third distance (d3) being different respectively from the first distance (d1) and from the second distance (d2), and,
- at least one third tie-rod, the or each third tie-rod being received in a third respective longitudinal hole.

6. Electric machine rotor (16) movable about an axis of rotation (X-X') comprising:
- a magnetic mass (23) according to any one of the preceding claims, and
- a short-circuit cage (22) extending along the axis of rotation (X-X') and including:
- two short-circuit rings (24, 26) placed on either side of the magnetic mass (23) along the axis of rotation (X-X'), and
- a plurality of electrically conductive bars (28), each electrically connecting the two short-circuit rings (24, 26) .

7. Electric machine (10) in particular asynchronous machine, particularly motor (10), comprising a stator (14) and a rotor (16), **characterised in that** the rotor (16) is according to claim 6.

8. Method for manufacturing a magnetic mass (23) for a rotor of an electric machine, the rotor being movable about an axis of rotation (X-X'), the method comprising the steps of:
- producing a magnetic mass (23) extending along the axis of rotation (X-X') and comprising magnetic rotor plates non-perforated at the centre thereof, the magnetic mass (23) including:
- a plurality of first longitudinal through-holes (34), each first longitudinal hole (34) being capable of receiving a first respective tie-rod (29) and being at a distance relative to the axis of rotation (X-X') along a radial direction substantially perpendicular to the axis of rotation (X-X') equal to a first distance (d1),
- at least one second longitudinal through-hole (35), the or each second longitudinal hole (35) being capable of receiving a second respective tie-rod (30) and being at a distance relative to the axis of rotation (X-X') along a radial direction substantially perpendicular to the axis of rotation (X-X') equal to a second distance (d2), the second distance (d2) being different from the first distance (d1),
- inserting a plurality of first tie-rods (29), each first tie-rod (29) being received in a first respective longitudinal hole (34)
- inserting at least one second tie-rod (30), the or each second tie-rod (30) being inserted in a second respective longitudinal hole (35), the second distance (d2) being less than or equal to 95% of the first distance (d1), preferably less than or equal to 90% of the first distance (d1), preferentially less than or equal to 70% of the first distance (d1), the number of first longitudinal holes (34) being equal to twice the number of second longitudinal holes (35).
